# EUROPEAN PATENT APPLICATION

(11) **EP 2 849 220 A2**
(43) Date of publication of application: **18.03.2015**
(21) Application number: 14175068.7
(22) Date of filing: 30.06.2014
(51) Int. Cl.: H01L 23/367

(54) **Semiconductor package and semiconductor device**

(30) Priority: 13.09.2013 JP 2013190751
(71) Applicant: Kabushiki Kaisha Toshiba, Tokyo 105-8001 (JP)
(72) Inventor: Kajio, Hiroshi, Minato-ku, Tokyo 105-8001 (JP)
(74) Representative: Granleese, Rhian Jane

(57) **Abstract**

Certain embodiments provide a semiconductor package including a base metal portion, a frame body, a plurality of wires, and a lid body. The base metal portion includes multiple grooves on a back surface, and can mount a semiconductor chip on a front surface. The frame body is arranged on the front surface of the base metal portion. The plurality of wires are arranged to penetrate through a side surface of the frame body. The lid body is arranged on the frame body.

## Description

### CROSS REFERENCE TO RELATED APPLICATIONS

This application is based upon and claims the benefit of priority from the prior Japanese Patent Application No.2013-190751 filed in Japan on September 13, 2013; the entire contents of which are incorporated herein by reference.

### FIELD

Embodiments described herein relate generally to a semiconductor package and a semiconductor device.

### BACKGROUND

A conventional semiconductor device has and uses a semiconductor chip mounted inside of a semiconductor package. In the conventional semiconductor device, the semiconductor package includes a base metal portion on which the semiconductor chip is mounted, a frame-shaped ceramic frame provided on this base metal portion so as to enclose the semiconductor chip, and a lid body attached to the ceramic frame. The semiconductor chip is sealed by the ceramic frame and the lid body in an air tight manner.

Such a conventional semiconductor device is used in such a manner that the conventional semiconductor device is mounted on a heat sink in order to radiate heat radiated by the semiconductor chip. The semiconductor device is preferably mounted on a heat sink with the thermal resistance which is as low as possible.

However, because of, e. g., the effects caused by difference in linear expansion coefficients of components constituting the semiconductor package, and difference in the shape of the semiconductor package in a cross section taken in parallel to the surface of the base metal portion, there are problems in that the base metal portion is warped and the entire semiconductor package is warped in the thermal step during a manufacturing step of the semiconductor package. When such a warped semiconductor package is mounted on a heat sink, an air layer is formed therebetween. This air layer does not serve as a heat radiation path, this increases the thermal resistance therebetween.

Known means for suppressing formation of an air layer between a semiconductor device and a heat sink includes means for sandwiching a heat radiation sheet between the heat sink and the base metal portion of the semiconductor package, and means for applying heat radiation grease to between the heat sink and the base metal portion of the semiconductor package.

However, for example, in a case where a power semiconductor releasing much heat such as an FET formed using GaAs, GaN, or the like is mounted as a semiconductor chip on a semiconductor package, it is difficult for the above method to sufficiently reduce the thermal resistance therebetween.

In this case, means for directly mounting the semiconductor device onto the heat sink by soldering may be considered. Solder has a higher thermal conductivity than the heat radiation sheet and the heat radiation grease. Therefore, the thermal resistance between the semiconductor device and the heat sink is considered to be able to be further reduced.

However, in normal circumstances, the back surface of the base metal portion of the semiconductor package is planarized in order to reduce, as much as possible, the thermal resistance between the semiconductor device and the heat sink. Therefore, the melted solder between the semiconductor device and the heat sink is difficult to spread on the planarized back surface of the base metal portion, and air bubbles may be formed in the solder.

When the air bubbles are formed in the solder in this manner, i.e., the quality of the solder is reduced, then, the thermal resistance between the semiconductor device and the heat sink increases.

### BRIEF DESCRIPTION OF THE DRAWINGS

FIG. 1 is a top view schematically illustrating a semiconductor device according to a first embodiment;
FIG. 2 is a cross sectional view of a semiconductor device taken along a dot-dash line A-A' in FIG. 1;
FIG. 3 is a cross sectional view a dot-dash line B-B' in FIG. 2;
FIG. 4 is a top view in a case where a semiconductor package of the semiconductor device according to the first embodiment is seen from the back surface side;
FIG. 5 is a figure illustrating the semiconductor device according to the first embodiment mounted on a heat sink, and is a cross sectional view corresponding to FIG. 2;
FIG. 6 is a figure illustrating the semiconductor device according to the first embodiment mounted on the heat sink, and is a cross sectional view corresponding to FIG. 3;
FIG. 7 is a top view illustrating how a conventional semiconductor device is mounted on a heat sink;
FIG. 8 is a figure illustrating how the conventional semiconductor device is mounted on a heat sink, and is a cross sectional view of the conventional semiconductor device taken along a dot-dash line C-C' in FIG. 7;
FIG. 9 is a figure illustrating a semiconductor device according to a modification of the first embodiment, and is a top view corresponding to FIG. 4;
FIG. 10 is a figure illustrating a semiconductor device according to a modification of the first embodiment, and is a cross sectional view corresponding to FIG. 2;
FIG. 11 is a figure illustrating a semiconductor device according to a modification of the first embodiment, and is a cross sectional view corresponding to FIG. 3;
FIG. 12 is a top view in a case where a semiconductor package of a semiconductor device according to a second embodiment is seen from the back surface side;
FIG. 13 is a cross sectional view of the semiconductor device according to the second embodiment taken along a dot-dash line D-D' in FIG. 12; and
FIG. 14 is a cross sectional view of the semiconductor device according to the second embodiment taken along a dot-dash line B-B' in FIG. 13.

### DESCRIPTION OF THE EMBODIMENTS

Certain embodiments provide a semiconductor package including a base metal portion, a frame body, a plurality of wires, and a lid body. The base metal portion includes multiple grooves on a back surface, and can mount a semiconductor chip on a front surface. The frame body is arranged on the front surface of the base metal portion. The plurality of wires are arranged to penetrate through a side surface of the frame body. The lid body is arranged on the frame body.

Certain embodiments provide a semiconductor device including a base metal portion, a semiconductor chip, a frame body, a plurality of wires, and a lid body. The base metal portion includes multiple grooves on a back surface. The semiconductor chip is mounted on a front surface of the base metal portion. The frame body is arranged on the front surface of the base metal portion so as to enclose the semiconductor chip. The plurality of wires are arranged to penetrate through a side surface of the frame body. One end of each of the plurality of wires is electrically connected to the semiconductor chip. The lid body is arranged on the frame body.

Hereinafter, a semiconductor package and a semiconductor device according to each of embodiments will be explained.

### (First embodiment)

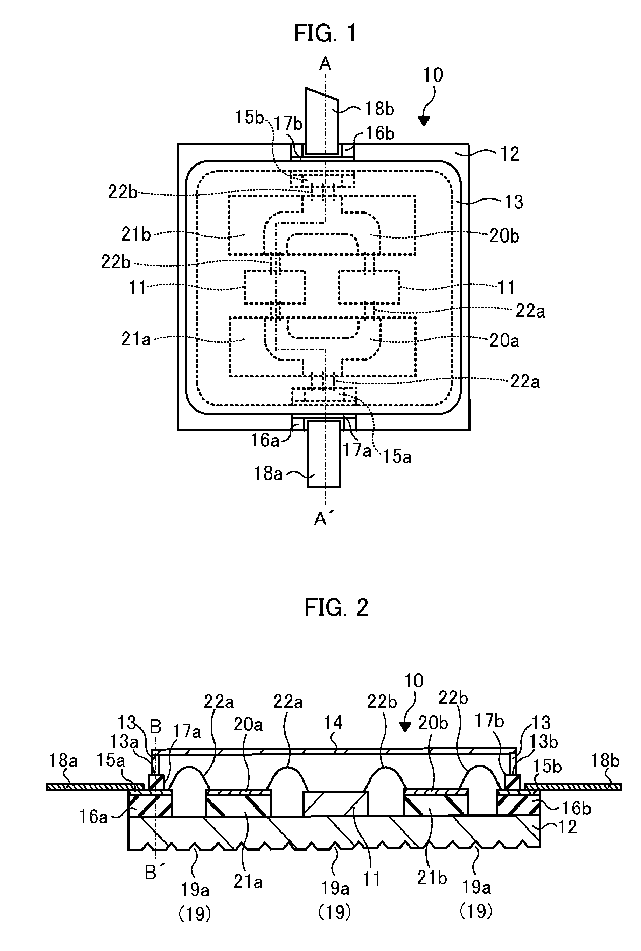

FIG. 1 is a top view schematically illustrating a semiconductor device according to the first embodiment. FIG. 2 is a cross sectional view of a semiconductor device taken along a dot-dash line A-A' in FIG. 1. In FIG. 1, the internal structure of the semiconductor package is indicated by a dotted line. A semiconductor device 10 as shown in FIGS. 1 and 2 has a semiconductor chip 11 mounted inside of the semiconductor package.

The semiconductor package includes a base metal portion 12, a frame body 13, and a lid body 14 (FIG. 2).

The base metal portion 12 can mount the semiconductor chip 11 and the like on its front surface. This metal portion 12 is formed by, for example, laminating different types of metals such as copper and molybdenum, or is formed using powder-metallurgy processing for mixing and fixing powders of different types of metals such as copper and tungsten. The copper has a high thermal conductivity, and the molybdenum and the tungsten has a linear expansion coefficient close to that of the semiconductor chip 11 made of, e.g., GaAs, or GaN. The base metal portion 12 made of different types of metals explained above has a high thermal conductivity. Further, the base metal portion 12 formed by the different types of metals as described above can suppress warping that occurs due to different in the linear expansion coefficient from the semiconductor chip 11 mounted thereon.

The frame body 13 is a ceramic frame made of, for example, a ceramic, and is arranged on the front surface of the base metal portion 12. The plate-like lid body 14 made of, for example, a ceramic which is the same material as the frame body 13 is provided on the frame body 13 (FIG. 2).

The semiconductor package explained above is provided with an input-side wire 15a for inputting a high frequency signal and the like into the semiconductor chip 11 mounted inside of the semiconductor package, and an output-side wire 15b for outputting a high frequency signal and the like processed by the semiconductor chip 11. These wires 15a, 15b are provided so as to penetrate through the frame body 13.

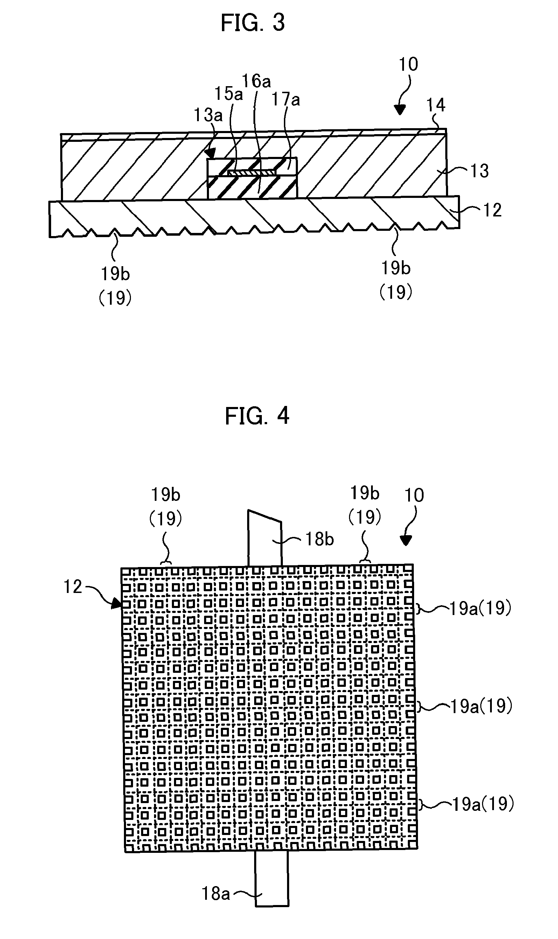

FIG. 3 is a cross sectional view of a semiconductor device taken along a dot-dash line B-B' in FIG. 2. As shown in FIG. 3, a concave portion 13a is provided on a side surface of the frame body 13. A first dielectric block 16a, an input-side wire 15a, and a second dielectric block 17a are provided in the concave portion 13a in such a manner that the concave portion 13a is filled with the first dielectric block 16a, the input-side wire 15a, and the second dielectric block 17a. The input-side wire 15a is provided on the first dielectric block 16a, and the second dielectric block 17a is provided on the first dielectric block 16a so as to cover the input-side wire 15a.

FIGS. 1 and 2 will be referred to. The first dielectric block 16a and the input-side wire 15a are provided to protrude from the inner side surface of the frame body 13 to the inside of the semiconductor package and also protrude from the outer side surface of the frame body 13 to the outside of the semiconductor package. Likewise, the second dielectric block 17a is also provided to protrude from the inner side surface of the frame body 13 to the inside of the semiconductor package and also protrude from the outer side surface of the frame body 13 to the outside of the semiconductor package. However, the second dielectric block 17a is provided to cover a part of the input-side wire 15a. In other words, the second dielectric block 17a is provided so that one end and the other end of the input-side wire 15a are exposed. An input lead 18a is provided at the other end of the input-side wire 15a, which is exposed from the second dielectric block 17a.

Although the same drawing as FIG. 3 is omitted, the output side has the same configuration. More specifically, a concave portion 13b is also provided on another side surface of the frame body 13 that is opposite to the side surface having the concave portion 13a. Like the input side, a first dielectric block 16b, an output-side wire 15b, and a second dielectric block 17b are provided in the concave portion 13b in such a manner that the concave portion 13b is filled with the first dielectric block 16b, the output-side wire 15b, and the second dielectric block 17b (FIGS. 1 and 2).

The first dielectric block 16b and the output-side wire 15b are provided to protrude from the inner side surface of the frame body 13 to the inside of the semiconductor package and also protrude from the outer side surface of the frame body 13 to the outside of the semiconductor package. Likewise, the second dielectric block 17b is also provided to protrude from the inner side surface of the frame body 13 to the inside of the semiconductor package and also protrude from the outer side surface of the frame body 13 to the outside of the semiconductor package. However, the second dielectric block 17b is provided so that one end and the other end of the output-side wire 15b are exposed. An output lead 18b is provided at the other end of the output-side wire 15b, which is exposed from the second dielectric block 17b.

FIG. 4 is a top view in a case where the semiconductor package explained above is seen from the back surface side. As shown in FIG. 4, multiple slits 19 are provided on the back surface of the semiconductor package. More specifically, the multiple slits 19 are provided on the back surface of the base metal portion 12. The multiple slits 19 are provided on the entire back surface of the base metal portion 12 in a mesh-like manner. More specifically, the multiple slits 19 are provided on the entire back surface of the base metal portion 12 in such a manner that multiple first slits 19a spaced apart from each other and arranged in parallel to each other cross to multiple second slits 19b spaced apart from each other and arranged in parallel to each other.

In the semiconductor device 10 according to the present embodiment, the multiple slits 19 are provided so that the multiple first slits 19a and the multiple second slits 19b cross each other substantially perpendicular to each other.

As shown in FIGS. 2 and 3, each of the slits 19 is provided so that the shape thereof in the vertical section is in a V shape. For example, each of the slits 19 is provided to have a depth equal to or less than about 1/3 of the thickness of the base metal portion 12, e.g., about 0.1 to 3.0 mm. In this case, the depth of the slit 19 means the distance between the back surface of the base metal portion 12 and the apex of the slit 19 (portions indicated by dotted line in FIG. 4).

The base metal portion 12 having the multiple slits 19 explained above is formed as follows, for example. First, the back surface of a metal plate serving as the base metal portion 12 is planarized by repeating milling for the metal plate until the center line average roughness on the back surface of the metal plate becomes, for example, about 1.6a. Subsequently, the multiple slits 19 are formed by processing the planarized back surface of the metal plate using, for example, a machining center. In this manner, the base metal portion 12 is formed.

It should be noted that the multiple slits 19 on the back surface of the base metal portion 12 may be, for example, multiple depressed portions of the metal plate before the milling process is finished. More specifically, when the center line average roughness of the back surface of the metal plate is 6.3a or more, multiple depressed portions of the back surface of the metal plate may be adopted as multiple slits. When the depressed portions are adopted as the slits, the number of repetition of the milling process for forming the base metal portion 12 and the processing step for forming the slits 19 can be omitted, and therefore, the base metal portion 12 can be easily formed.

In the present application the slit 19 and the depressed portion will be hereinafter referred to as groove, but in the explanation about the embodiments, a case where the groove is the slit 19 will be explained.

FIGS. 1 and 2 will be referred to. The semiconductor chip 11 and the input/output matching circuit patterns 20a, 20b are mounted in the semiconductor package having the base metal portion 12 having the multiple slits 19 provided on its back surface as explained above. The semiconductor chip 11 and the input/output matching circuit patterns 20a, 20b are mounted in such a manner that the semiconductor chip 11 and the input/output matching circuit patterns 20a, 20b are enclosed by the frame body 13 on the front surface of the base metal portion 12.

The semiconductor chip 11 is a power semiconductor such as a high-power transistor (GaN-HEMT) using, for example, gallium nitride, and is mounted on the front surface of the base metal portion 12. As shown in FIG. 1, in the semiconductor device 10 according to the embodiment, two semiconductor chips 11 are mounted on the front surface of the base metal portion 12. However, the number of semiconductor chips 11 mounted on the front surface of the base metal portion 12 is not limited. Moreover, the semiconductor chip 11 mounted on the front surface of the base metal portion 12 is not limited to a power semiconductor.

The input matching circuit pattern 20a is provided on the surface of the dielectric substrate 21 a which is provided between the input-side wire 15a and the semiconductor chip 11 on the front surface of the base metal portion 12. One end of the matching circuit pattern 20a is connected to the semiconductor chip 11, and the other end of the matching circuit pattern 20a is connected to one end of the input-side wire 15a. A connection conductor 22a such as a wire connects between one end of the matching circuit pattern 20a and the semiconductor chip 11 and between the other end of the matching circuit pattern 20a and one end of the input-side wire 15a.

The output matching circuit pattern 20b is provided on the surface of the dielectric substrate 21 b which is provided between the output-side wire 15b and the semiconductor chip 11 on the front surface of the base metal portion 12. One end of the matching circuit pattern 20b is connected to the semiconductor chip 11, and the other end of the matching circuit pattern 20b is connected to one end of the output-side wire 15b. A connection conductor 22b such as a wire connects between one end of the matching circuit pattern 20b and the semiconductor chip 11 and between the other end of the matching circuit pattern 20b and one end of the output-side wire 15b.

As shown in FIG. 1, in the semiconductor device 10 according to the embodiment, two semiconductor chips 11 are mounted on the front surface of the base metal portion 12. Therefore, the input matching circuit pattern 20a is demultiplexing circuit into two paths in a direction from the input-side wire 15a to the semiconductor chip 11, and the output matching circuit pattern 20b is a multiplexing circuit for combining two paths in a direction from the semiconductor chip 11 to the output-side wire 15b. However, the number of paths into which the input matching circuit pattern 20a is divided, and the number of paths the output matching circuit pattern 20b combines are each determined by the number of mounted semiconductor chips 11.

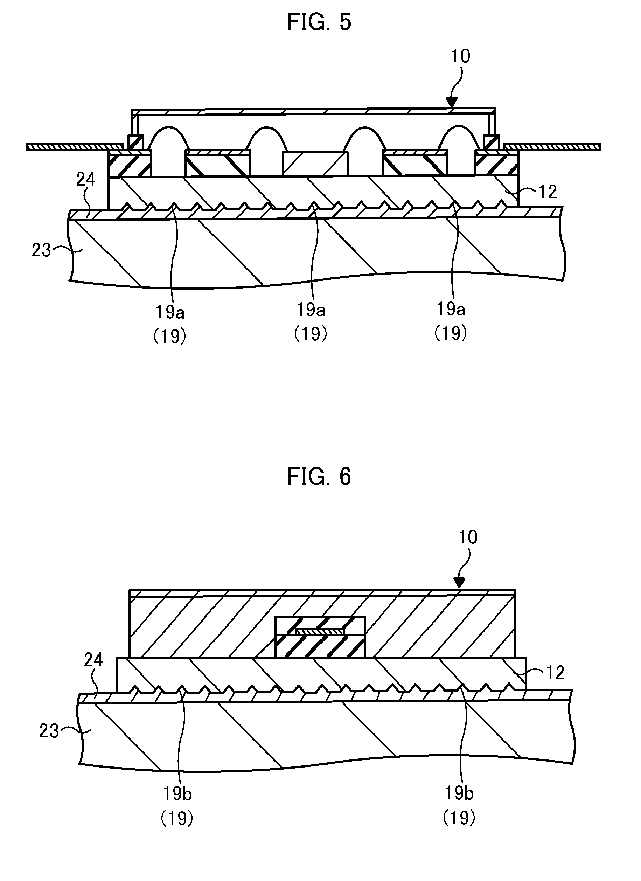

FIGS. 5 and 6 are figures illustrating the semiconductor device according to the present embodiment mounted on the heat sink. FIG. 5 is a cross sectional view corresponding to FIG. 2. FIG. 6 is a cross sectional view corresponding to FIG. 3. As shown in FIGS. 5 and 6, the semiconductor device 10 is mounted on the planarized surface of the heat sink 23 through the solder 24. The solder 24 is provided so as to be in contact with the entire surface of the back surface of the semiconductor device 10 and so as to fill the insides of the slits 19 of the base metal portion 12, and the semiconductor device 10 is mounted on the planarized surface of the heat sink 23 through the solder 24.

According to the semiconductor package and the semiconductor device 10 according to the present embodiment explained above, the multiple slits 19 are provided on the back surface of the base metal portion 12, and therefore, it is possible to suppress warping of the base metal portion 12 and it is possible to suppress warping of the semiconductor package and the semiconductor device 10. Hereinafter this effect will be explained.

In the thermal step during manufacturing of the semiconductor package, a phenomenon occurs that the base metal portion is warped in accordance with difference in linear expansion coefficients of components constituting the semiconductor package, and the shape of the semiconductor package and the components constituting the semiconductor package. This phenomenon occurs because stress occurs in each portion of the base metal portion in the thermal step during manufacturing of the semiconductor package, and this stress causes the length of the surface of the base metal portion to be different from the length of the back surface of the base metal portion.

For example, the phenomenon that the base metal portion warps in a protruding shape occurs when the stress makes the length of the surface of the base metal portion be longer and makes the length of the back surface of the base metal portion be shorter. However, when such stress occurs in the base metal portion 12 having the multiple slits 19 on the back surface, the width of each slit 19 expands. =Therefore, it is suppressed that the length of the front surface of the base metal portion 12 and the length of the back surface of the base metal portion 12 are different from each other. As a result, it is suppressed that the base metal portion 12 warps in a protruding shape.

On the other hand, the phenomenon that the base metal portion warps in a depressed shape occurs when the stress makes the length of the surface of the base metal portion be shorter and makes the length of the back surface of the base metal portion be longer. However, when such stress occurs in the base metal portion 12 having the multiple slits 19 on the back surface, the width of each slit 19 shrinks. Therefore, it is suppressed that the length of the front surface of the base metal portion 12 and the length of the back surface of the base metal portion 12 are different from each other. As a result, it is suppressed that the base metal portion 12 warps in a depressed shape.

As described above, according to the semiconductor package and the semiconductor device 10 according to the present embodiment, it is suppressed that the length of the front surface of the base metal portion 12 and the length of the back surface of the base metal portion 12 are different from each other because the widths of the multiple slits 19 provided on the back surface of the base metal portion 12 expand or shrink. As a result, it is possible to suppress warping of the base metal portion 12, and it is possible to suppress warping of warping of the semiconductor package and the semiconductor device 10.

Subsequently, according to the semiconductor package and the semiconductor device 10 according to the present embodiment explained above, the multiple slits 19 are provided on the back surface of the base metal portion 12, and therefore, the quality of the solder 24 for mounting the semiconductor device 10 on the heat sink 23 can be improved. This effect will be hereinafter explained while the method for mounting the semiconductor device 10 on the heat sink 23 is explained.

First, a predetermined amount of solder 24 is formed at a predetermined position on the surface of the heat sink 23, and the solder 24 is heated and melted.

Subsequently, the semiconductor device 10 is aligned and arranged so that the melted solder 24 is in contact with the back surface of the semiconductor device 10. When the melted solder 24 is brought into contact with the back surface of the semiconductor device 10, the melted solder 24 spreads very well on the entire back surface of the semiconductor device 10 due to the capillary phenomenon of the slit 19. At this occasion, air bubbles sealed between the semiconductor device 10 and the heat sink 23 are emitted to the outside of the semiconductor device 10 via the slits 19.

Finally, the solder 24 that has spread on the entire back surface of the semiconductor device 10 is cooled and solidified. Therefore, as shown in FIGS. 5 and 6, the semiconductor device 10 is mounted on the heat sink 23.

When the solder 24 is formed on the surface of the heat sink 23, and the solder is also formed on the back surface of the semiconductor device 10 in advance, the workability of the mounting work is improved, and the semiconductor device 10 can be easily mounted on the heat sink 23.

As explained above, according to the semiconductor package and the semiconductor device 10 of the present embodiment, the multiple slits 19 are provided on the back surface of the base metal portion 12, so that the melted solder 24 can be easily spread on the entire back surface of the semiconductor device 10 by the capillary phenomenon. Further, each slit 19 serves as a emission path for emitting the air bubbles sealed between the semiconductor device 10 and the heat sink 23 to the outside of the semiconductor device 10, and therefore, it is suppressed that the air bubbles are formed in the solder 24 between the heat sink 23 and the semiconductor device 10. Thus, it is possible to improve the quality of the solder 24.

As described above, according to the semiconductor package and the semiconductor device 10 of the present embodiment, the multiple slits 19 are provided on the back surface of the base metal portion 12, and therefore, it is suppressed that the base metal portion 12 warps, and it is possible to improve the quality of the solder 24 for mounting. As a result, the thermal resistance between the semiconductor device 10 and the heat sink 23 can be reduced.

The above explanation is about a case where the base metal portion 12 having the multiple slits 19 provided on its back surface is applied, but the same effect can also be obtained by applying a base metal portion having multiple depressed portions where the center line average roughness of the back surface is 6.3a or more.

### (Modification)

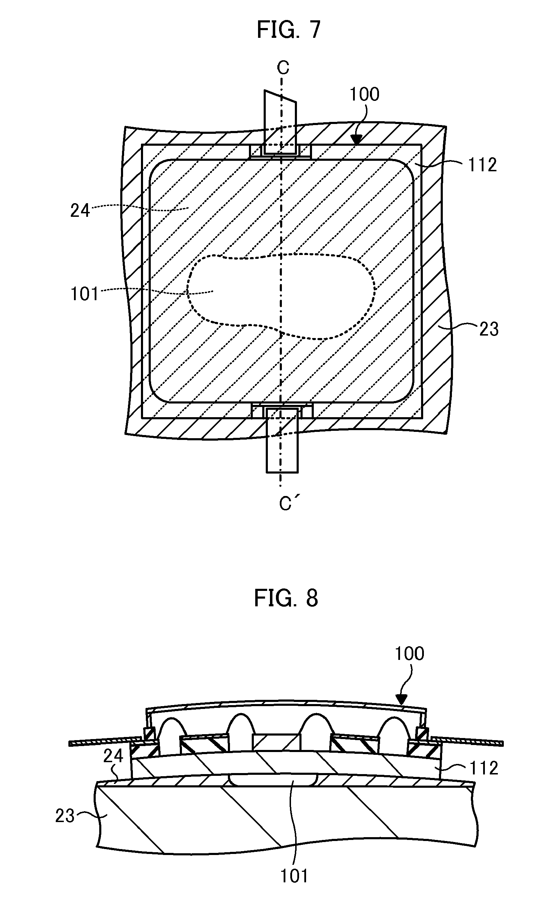

Hereinafter, a modification of the semiconductor package and the semiconductor device 10 according to the first embodiment will be explained. Then, first, a conventional semiconductor device mounted on a heat sink will be explained with reference to FIGS. 7 and 8. FIGS. 7 and 8 are top views illustrating how a conventional semiconductor device is mounted on a heat sink. FIG. 7 is a top view in a case where the conventional semiconductor device is seen from above. FIG. 8 is a cross sectional view of the conventional semiconductor device taken along a dot-dash line C-C' in FIG. 7.

As shown in FIGS. 7 and 8, when the conventional semiconductor device 100 having the base metal portion 112 of which a back surface is planarized is mounted on the heat sink 23, an air layer 101 is likely to be formed in the solder 24, which is for mounting the semiconductor device 100 on the heat sink 23, under a central area of the semiconductor device 100. This air layer 101 does not serve as the heat radiation path, and therefore, when the semiconductor device 100 is mounted on the heat sink 23 as described above, the thermal resistance therebetween increases.

In this case, according to the semiconductor package and the semiconductor device 10 according to the first embodiment, the multiple slits 19 are provided on the entire back surface of the base metal portion 12. However, the multiple slits 19 may not be necessarily provided on the entire back surface of the base metal portion 12, and the multiple slits 19 may be provided only in a part of the back surface of the base metal portion 12.

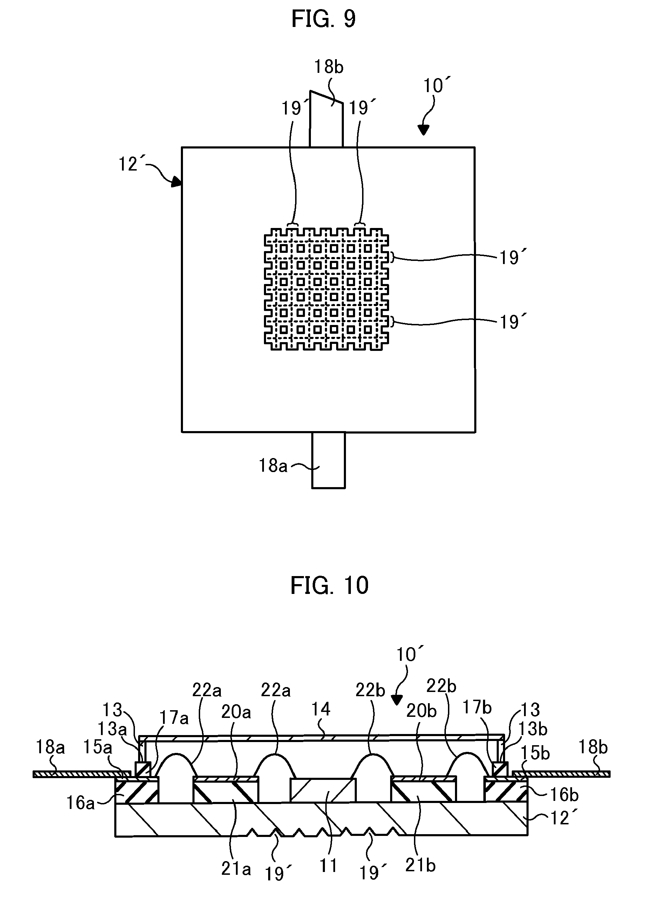

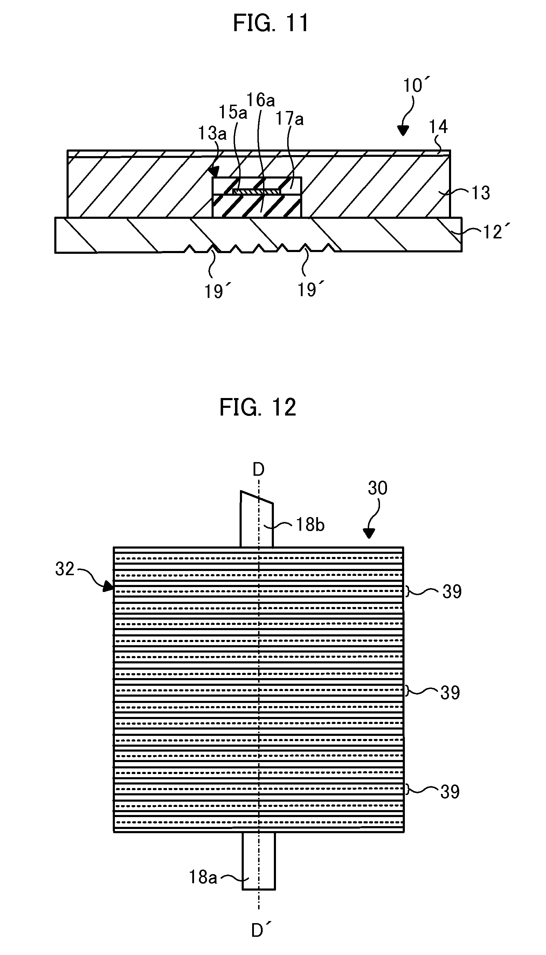

FIGS. 9, 10, and 11 are figure illustrating a semiconductor package and a semiconductor device according to the modification. FIG. 9 is a top view corresponding to FIG. 4. FIG. 10 is a cross sectional view corresponding to FIG. 2. FIG. 11 is a cross sectional view corresponding to FIG. 3. In FIGS. 9 to 11, the same portions as those of the semiconductor device 10 according to the first embodiment are denoted with the same reference numerals.

For example, as shown in FIGS. 7 and 8, when the air layer 101 is likely to be formed in the solder 24 under a central area of the semiconductor device 100, multiple slits 19' may be provided only in an area where the air layer 101 is likely to be formed and immediately under the semiconductor chip 11 that generates heat as shown in FIGS. 9, 10, and 11. More specifically, for example, the multiple slits 19' may be provided only in the central area of the back surface of the base metal portion 12'. Even the semiconductor package and the semiconductor device 10' according to the modification in which the multiple slits 19' are provided only in a part of the back surface of the base metal portion 12' as described above can also provide the same effects as those of the semiconductor package and the semiconductor device 10 according to the first embodiment.

### (Second embodiment)

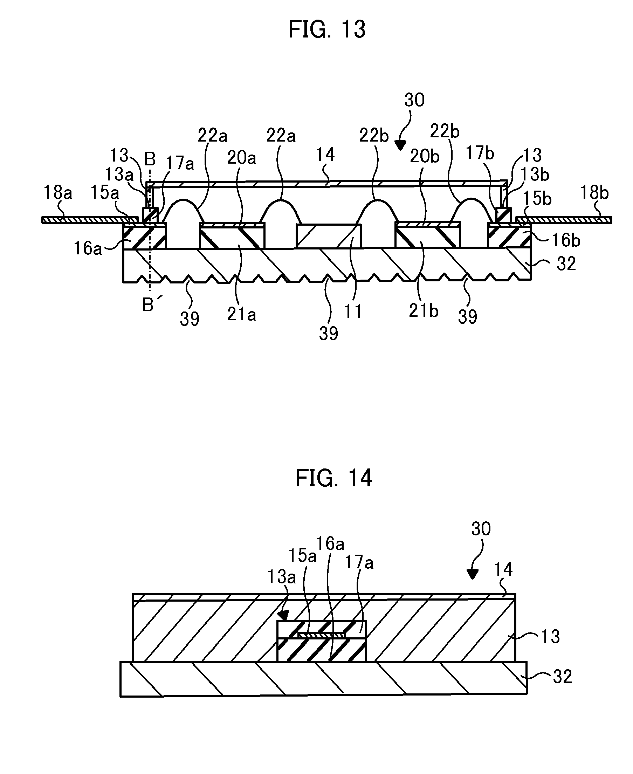

FIG. 12 is a top view in a case where a semiconductor package of a semiconductor device according to the second embodiment is seen from the back surface side. FIG. 13 is a cross sectional view of the semiconductor device according to the second embodiment taken along a dot-dash line D-D' in FIG. 12. FIG. 14 is a cross sectional view of the semiconductor device according to the second embodiment taken along a dot-dash line B-B' in FIG. 13. Hereinafter, the semiconductor device 30 according to the second embodiment will be explained with reference to FIGS. 12 to 14. In the explanation below, the same portions as those of the semiconductor device 10 according to the first embodiment are denoted with the same reference numerals, and explanation thereabout is omitted.

As shown in FIGS. 12 to 14, as compared with the semiconductor device 10 according to the first embodiment, the semiconductor device 30 according to the second embodiment is different in the configuration of slits 39 provided on the back surface of the base metal portion 32 of the semiconductor package.

More specifically, in the semiconductor device 30 according to the second embodiment, multiple slits 39 are arranged on the entire back surface of the base metal portion 32 of the semiconductor package in such a manner that the multiple slits 39 are in parallel to each other and in a stripe manner.

As shown in FIG. 13, each of the slits 39 is provided so that the shape thereof in the vertical section is in a V shape. For example, each of the slits 39 is provided so as to have a depth equal to or less than about 1/3 or of the thickness of the base metal portion 32 or less, e.g., about 0.1 to 3.0 mm. In this case, the depth of the slit 39 means the distance between the back surface of the base metal portion 32 and the apex of the slit 39 (portions indicated by dotted lines in FIG. 12).

The base metal portion 32 having the multiple slits 39 is formed in the same manner as the base metal portion 12 of the semiconductor package provided in the semiconductor device 10 according to the first embodiment.

The multiple slits 39 on the back surface of the base metal portion 32 may be, for example, multiple depressed portions of the metal plate before the milling process is finished. More specifically, when the center line average roughness of the back surface of the metal plate is 6.3a or more, multiple depressed portions of the back surface of the metal plate may be adopted as multiple slits 39. This feature is also the same as that of the base metal portion 12 of the semiconductor package provided in the semiconductor device 10 according to the first embodiment.

Like the semiconductor device 10 according to the first embodiment, the semiconductor device 30 explained above is also mounted on the heat sink 23 with the solder 24 interposed therebetween, but at that occasion, the solder 24 is provided to be in contact with the entire back surface of the semiconductor device 30 including the insides of the slits 39.

In the semiconductor package and the semiconductor device 30 according to the present embodiment explained above, the multiple slits 39 are provided on the back surface of the base metal portion 32, and therefore, it is suppressed that the base metal portion 32 warps, and it is possible to improve the quality of the solder 24 for mounting. As a result, the thermal resistance between the semiconductor device 30 and the heat sink 23 can be reduced.

It should be noted that the semiconductor device 30 according to the present embodiment can also provide the same effect by applying the base metal portion having multiple depressed portions where the center line average roughness of the back surface is 6.3a or more. Although not shown in the drawings, like the modification of the semiconductor device according to the first embodiment, the multiple slits 39 in parallel to each other may be provided only in a part of the base metal portion 32 such as a center area of the base metal portion 32, and even with such semiconductor device, the same effects as those of the semiconductor device according to the present embodiment can be obtained.

While certain embodiments have been described, these embodiments have been presented by way of example only, and are not intended to limit the scope of the inventions. Indeed, the novel embodiments described herein may be embodied in a variety of other forms; furthermore, various omissions, substitutions and changes in the form of the embodiments described herein may be made without departing from the spirit of the inventions. The accompanying claims and their equivalents are intended to cover such forms or modifications as would fall within the scope and spirit of the inventions.

## Claims

1. A semiconductor package comprising:
a base metal portion including a plurality of grooves on a back surface, and capable of mounting a semiconductor chip on a front surface;
a frame body arranged on the front surface of the base metal portion;
a plurality of wires arranged to penetrate through a side surface of the frame body; and
a lid body arranged on the frame body.

2. The semiconductor package according to claim 1, wherein the plurality of grooves are provided on the entire back surface of the base metal portion.

3. The semiconductor package according to claim 1, wherein the plurality of grooves are provided in a center portion of the back surface of the base metal portion.

4. The semiconductor package according to claim 2 or 3, wherein each of the plurality of grooves is a slit.

5. The semiconductor package according to claim 4, wherein a plurality of slits are arranged in a mesh-like manner.

6. The semiconductor package according to claim 4, wherein a plurality of slits are arranged in a stripe manner.

7. The semiconductor package according to claim 1, wherein the base metal portion has a plurality of depressed portions where a center line average roughness of the back surface is 6.3a or more, and
the plurality of grooves are depressed portions provided in the base metal portion.

8. A semiconductor device comprising:
a semiconductor package according to any preceding claim;
the device further comprising a semiconductor chip mounted on a front surface of the base metal portion of said package, and wherein
the frame body is arranged on the front surface of the base metal portion so as to enclose the semiconductor chip, and
one end of each of the plurality of wires is electrically connected to the semiconductor chip.

9. The semiconductor device according to claim 8, wherein the semiconductor device is mounted on a planarized surface of a heat sink through a solder.
